# EUROPÄISCHE PATENTSCHRIFT

(11) **EP 3 949 700 B1**
(45) Veröffentlichungstag und Bekanntmachung des Hinweises auf die Patenterteilung: **17.07.2024**
(21) Anmeldenummer: 20711789.6
(22) Anmeldetag: 09.03.2020
(51) Int. Cl.: H05K 5/06, H05K 7/14

(54) **ELEKTROGERÄT, INSBESONDERE UMRICHTERMOTOR, MIT EINEM GEHÄUSETEIL UND EINEM DECKELTEIL**
ELECTRICAL DEVICE, IN PARTICULAR CONVERTER MOTOR, HAVING A HOUSING PART AND A COVER PART
APPAREIL ÉLECTRIQUE, EN PARTICULIER MOTEUR CONVERTISSEUR, COMPORTANT UNE PARTIE BOÎTIER ET UNE PARTIE COUVERCLE

(30) Priorität: 04.04.2019 DE 102019002462
(43) Veröffentlichungstag der Anmeldung: 09.02.2022
(73) Patentinhaber: SEW-EURODRIVE GmbH & Co. KG, 76646 Bruchsal (DE)
(72) Erfinder: MAYER, Ralph, 76698 Ubstadt-Weiher (DE); DAMINGER, Franz, 67067 Ludwigshafen am Rhein (DE)
(86) Internationale Anmeldenummer: PCT/EP2020/025118
(87) Internationale Veröffentlichungsnummer: WO 2020/200515

(56) Entgegenhaltungen:
- WO-A1-2018/224217
- DE-A1- 102004 038 690
- DE-A1- 102013 112 096

## Beschreibung

Die Erfindung betrifft ein Elektrogerät, insbesondere Umrichtermotor, mit einem Gehäuseteil und einem Deckelteil.

Es ist allgemein bekannt, dass ein Gehäuse mittels Dichtungen in hoher Schutzart ausführbar ist.

**Aus der** DE 10 2004 038690 A1 **ist als nächstliegender Stand der Technik ein mehrteiliges Gehäuse für eine elektronische Schaltung bekannt.**

**Aus der** DE 10 2013 112096 A1 **ist ein Funktionskomponentengehäuse mit einer Dichtung bekannt.**

**Aus der** WO 2018/224217 A1 **ist ein Gehäuse für ein Elektrogerät mit einem dicht angeformten Gehäuseteil.**

Der Erfindung liegt daher die Aufgabe zugrunde, ein Elektrogerät in einfacher Weise in hoher Schutzart weiterzubilden.

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Umrichtermotor, mit einem Gehäuseteil und einem Deckelteil sind, dass ein Rahmenteil zwischen den Gehäuseteil und dem Deckelteil angeordnet ist,
wobei in dem vom aus dem Gehäuseteil und dem Deckelteil, insbesondere und dem Rahmenteil, gebildeten Gehäuse umgebenen Innenraum eine elektronische Schaltung angeordnet ist,
wobei am Rahmenteil eine Dichtung angeordnet ist, insbesondere angespritzt angeordnet ist,
wobei die Dichtung sowohl eine am Deckelteil ausgebildete insbesondere ebene Verbindungsfläche berührt, insbesondere und somit zwischen Rahmenteil und Deckelteil abdichtet, als auch eine am Gehäuseteil ausgebildete insbesondere ebene Verbindungsfläche berührt, insbesondere und somit zwischen Rahmenteil und Gehäuseteil abdichtet,
wobei ein Bereich der Verbindungsfläche des Deckelteils das Rahmenteil berührt,
wobei ein Bereich der Verbindungsfläche des Gehäuseteils das Rahmenteil berührt.

Von Vorteil ist dabei, dass das Rahmenteil eine Dichtung bereitstellt, die zwischen Gehäuseteil und Deckelteil angeordnet wird und somit das Deckelteil zum Gehäuseteil dicht verbindbar ist. Hierzu ist die Dichtung vom Rahmenteil stoffschlüssig gehalten. Auf diese Weise ist bei der Montage eine präzise Positionierung ausführbar. Insbesondere weist das Gehäuseteil hierzu Positioniermittel, wie Zapfen auf, welche in eine Ausnehmung des Rahmenteils hineinragen. Außerdem müssen das Deckelteil und das Gehäuseteil jeweils nur eine ebene Fläche bereitstellen, auf welche die Dichtung drückt und somit abdichtet. Die Verbindungsflächen sind jeweils fein bearbeitet.

Bei einer vorteilhaften Ausgestaltung umgibt die Dichtung den vom Innenraum aus gesehen äußeren Randbereich des Rahmenteils,
insbesondere wobei ein erster Bereich der Dichtung auf der dem Deckelteil zugewandten Seite des Rahmenteils angeordnet ist und wobei ein zweiter Bereich der Dichtung auf der dem Gehäuseteil zugewandten Seite des Rahmenteils angeordnet ist. Von Vorteil ist dabei, dass die Dichtung einstückig von einer ersten, dem Deckelteil zugewandten Seite des Rahmenteils bis zu einer zweiten, dem Gehäuseteil zugewandten Seite des Gehäuseteils sich erstreckt. Auf diese Weise ist eine lückenfreie Abdichtung erreichbar. Denn das Rahmenteil ist somit nicht an der Dichtfunktion direkt beteiligt, sondern dient nur dem Halten der Dichtung und der Vorgabe eines definierten Verformungswegs für die Verformung der Dichtung.

Bei einer vorteilhaften Ausgestaltung ist eine durch das Deckelteil und durch das Rahmenteil durchgehende Schraube in eine im Gehäuseteil angeordnete Gewindebohrung eingeschraubt, wobei der Schraubenkopf der Schraube das Deckelteil zum Gehäuseteil hindrückt, so dass das Deckelteil das Rahmenteil berührt und, insbesondere auf der vom Deckelteil abgewandten Seite des Rahmenteils, dass Rahmenteil das Gehäuseteil berührt. Von Vorteil ist dabei, dass mittels der Schraube das Gehäuseteil und das Deckelteil zum Rahmenteil auf Block schraubbar sind, also bis zur Herstellung der vollständigen Berührung der jeweiligen Verbindungsflächen mit dem Rahmenteil. Somit ist die Einschraubtiefe der Schraube durch das Rahmenteil begrenzt und dadurch auch die Verformung der Dichtung. Da die Dichtung aber übersteht, wird sie nur soweit verformt, bis die Verbindungsflächen eben am Rahmenteil anliegen.

Bei einer vorteilhaften Ausgestaltung ist das Rahmenteil aus Metall gefertigt und die Dichtung aus einem Kunststoff und/oder Gummi. Von Vorteil ist dabei, dass eine einfache Kostengünstige Herstellung ermöglicht ist, wobei das Rahmenteil stabil und die Dichtung elastisch verformbar ausgeführt sind.

Bei einer vorteilhaften Ausgestaltung ist das Rahmenteil im Wesentlichen rechteckförmig ausgeformt. Von Vorteil ist dabei, dass der Innenraum ein großes Volumen umgibt und eine rechteckförmige Leiterplatte aufnehmbar ist, auf der die Elektronik eines Umrichters bestückbar ist. Zwischen Leiterplatte und Rahmenteil ist somit eine optimale Raumnutzung ermöglicht.

**Erfindungsgemäß** weist das Rahmenteil Laschenbereiche, insbesondere bügelartig ausgeformte Laschenbereiche auf, welche an am Gehäuseteil ausgeformten Nasenbereichen, insbesondere an an der Innenwandung des Gehäuseteils in den Innenraum hervorragend angeformten Nasenbereichen, formschlüssig gehalten sind, insbesondere eingeklipst sind. Von Vorteil ist dabei, dass die Laschenbereiche einklipsbar sind in die Nasenbereiche und somit das Rahmenteil positionierbar und verbindbar ist mit dem Gehäuseteil. Somit ist beim Aufsetzen des Deckelteils das Rahmenteil schon am Gehäuseteil positioniert.

Bei einer vorteilhaften Ausgestaltung weist der jeweilige Nasenbereich eine Einführschräge auf, insbesondere wobei der Nasenbereich in Richtung der Schraubachse der Schraube zunehmend in den Innenraum hervorragt,
insbesondere wobei der Nasenbereich hinter der Einführschräge weniger in den Innenraum hervorragt als im Nasenbereich. Von Vorteil ist dabei, dass beim Aufsetzen des Rahmenteils die Laschenbereiche zunehmend in den Innenraum elastisch abgelenkt werden, bis die Laschenbereiche einschnappen am Nasenbereich.

Bei einer vorteilhaften Ausgestaltung ist der jeweilige Nasenbereich als jeweilige Verdickung der Wand des Gehäuseteils ausgeführt. Von Vorteil ist dabei, dass die Wand eine erhöhte Stabilität aufweist und der Nasenbereich einfach und kostengünstig, insbesondere beim Gießen urgeformt, herstellbar ist.

Bei einer vorteilhaften Ausgestaltung ist die Gewindebohrung in einer Verdickung der Wand des Gehäuseteils ausgeführt,
insbesondere wobei die Verdickung von den Nasenbereichen beabstandet ist und in den Innenraum hervorragt. Von Vorteil ist dabei, dass das Rahmenteil eine erhöhte Stabilität aufweist und für die Herstellung der Gewindebohrung kein erhöhter Aufwand notwendig ist. Somit ist schon in der Urform die Verdickung berücksichtigbar.

Bei einer vorteilhaften Ausgestaltung sind die Verbindungsflächen parallel zu einer Ebene ausgerichtet sind, deren Normale parallel zur Schraubachsrichtung der Schraube ist. Von Vorteil ist dabei, dass

Bei einer vorteilhaften Ausgestaltung sind die Laschenbereiche am Rahmenteil, insbesondere aus einer zur Ebene parallelen Ebene, in Richtung der Schraubenachse herumgebogen. Von Vorteil ist dabei, dass das Rahmenteil als Stanz-Biegeteil herstellbar ist aus einem Metallblech. Somit ist eine erhöhte Stabilität in einfacher Weise erreichbar. Außerdem ist durch Herunterbiegen der Laschenbereiche ein Auslenken der Laschenbereich senkrecht zur Aufsetzrichtung erreichbar und somit ein Einklipsen, also ein in Aufsetzrichtung wirksamer Formschluss.

Bei einer vorteilhaften Ausgestaltung weist das Rahmenteil eine insbesondere in Schraubachsrichtung der Schraube durchgehende Ausnehmung auf,
in welche ein am Gehäuseteil ausgeformter Zapfen hineinragt,
insbesondere wobei der Zapfen in einer Verdickung der Wand des Gehäuseteils ausgeführt ist,
insbesondere wobei die Verdickung von den Nasenbereichen beabstandet ist und in den Innenraum hervorragt. Von Vorteil ist dabei, dass eine Feinpositionierung ohne besonderen Aufwand ermöglicht ist. Mittels der Laschenbereiche ist bei deren Einklipsen an den Nasenbereichen eine grobe Positionierung erreichbar, mittels der Zapfen hingegen ist eine Feinpositionierung zusätzlich erreichbar.

Bei einer vorteilhaften Ausgestaltung weist das Gehäuseteil an seiner Unterseite eine Ausnehmung auf,
wobei das Gehäuseteil auf einem Anschlusskastenansatz eines Elektromotors angeordnet ist,
wobei Statorleitungen des Stators des Elektromotors durch die Ausnehmung in den vom Gehäuse umgebenen Innenraum hineingeführt sind,
insbesondere wobei im Innenraum ein Umrichter angeordnet ist. Von Vorteil ist dabei, dass das Gehäuseteil auf einen Elektromotor aufsetzbar ist. Somit ist ein Elektrogerät am Elektromotor integriert ausbildbar und im Feld einsetzbar, da das Gehäuse mittels des Rahmenteils abgedichtet ist.

Bei einer vorteilhaften Ausgestaltung ist die Dichtung mit dem Rahmenteil als Verbundteil ausgeführt ist. Von Vorteil ist dabei, dass eine einfache Herstellung erreichbar ist.

Bei einer vorteilhaften Ausgestaltung weist die Dichtung auf der zum Deckelteil zugewandten Seite des Rahmenteils eine erste Dichtlippe auf, welche am Rahmenteil umlaufend ausgeformt ist und stärker elastisch verformt ist als das restliche Material der Dichtung auf der zum Deckelteil zugewandten Seite des Rahmenteils,
wobei die Dichtung auf der zum Gehäuseteil zugewandten Seite des Rahmenteils eine zweite Dichtlippe aufweist, welche am Rahmenteil umlaufend ausgeformt ist und stärker elastisch verformt ist als das restliche Material der Dichtung auf der zum Gehäuseteil zugewandten Seite des Rahmenteils. Von Vorteil ist dabei, dass eine hohe Dichtigkeit, also hohe Schutzart, in einfacher kostengünstiger Weise erreichbar ist.

Bei einer vorteilhaften Ausgestaltung ragt die Schraube durch ein im Rahmenteil angeordnetes Loch hindurch, welches in jeder der beiden Verbindungsflächen, insbesondere also am Rahmenteil beidseitig, zum Innenraum hin und zur Umgebung hin von der Dichtung abgedichtet ist. Von Vorteil ist dabei, dass eine hohe Schutzart erreichbar ist und die Schraube vor Korrosion schützbar ist.

Bei einer vorteilhaften Ausgestaltung umgibt die erste Dichtlippe in der ersten der beiden Verbindungsflächen die Schraube vollständig, insbesondere dichtet also zum Innenraum und zur äußeren Umgebung hin ab,
wobei die zweite Dichtlippe in der zweiten der beiden Verbindungsflächen die Schraube vollständig umgibt, insbesondere also zum Innenraum und zur äußeren Umgebung hin abdichtet. Von Vorteil ist dabei, dass die schraube vor Korrosion geschützt ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

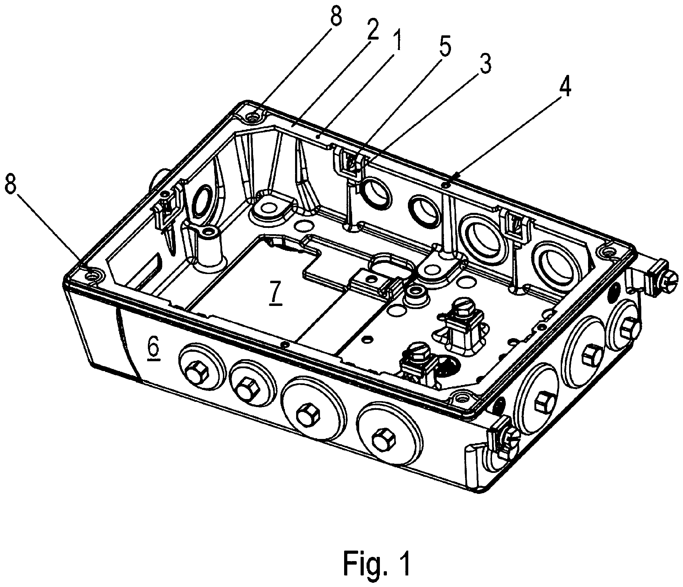

In der Figur 1 ist ein Gehäuseteil 6 mit aufgesetztem Rahmenteil 1 in Schrägansicht dargestellt.

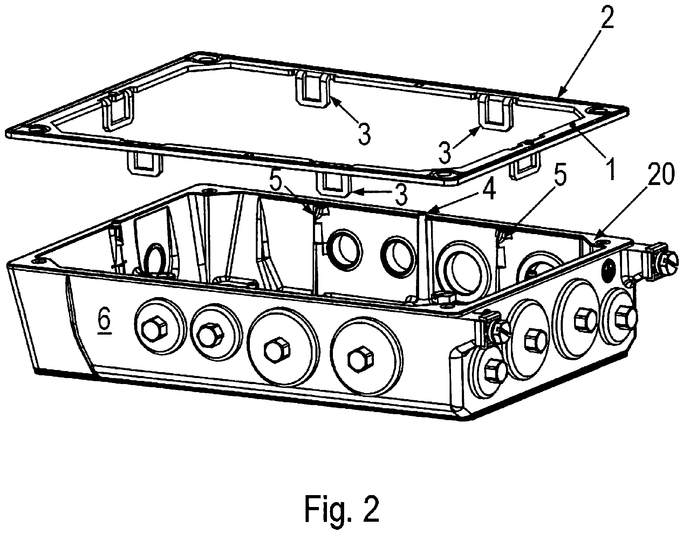

In der Figur 2 ist das Rahmenteil 1 vom Gehäuseteil 6 abgehoben in Schrägansicht dargestellt.

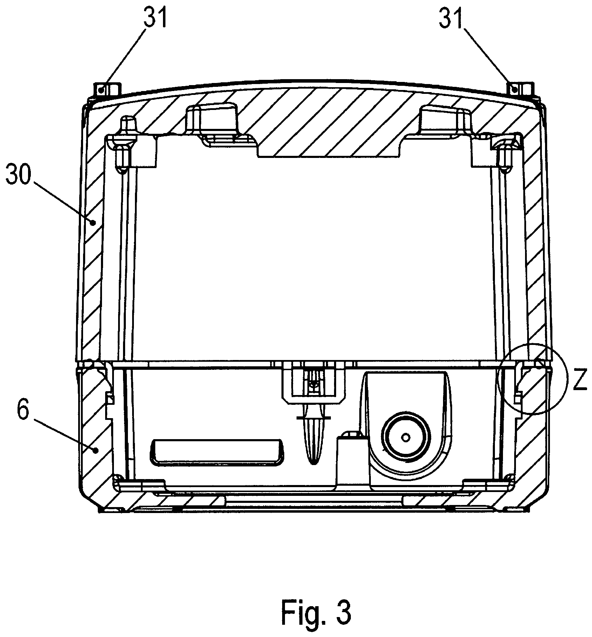

In der Figur 3 ist ein Querschnitt durch ein aus dem Gehäuseteil 6 mit auf dem Rahmenteil 1 aufgesetztem Deckelteil 30 gebildetes Gehäuse dargestellt.
In der Figur 4 ist ein Ausschnitt aus der Figur 3 vergrößert dargestellt.

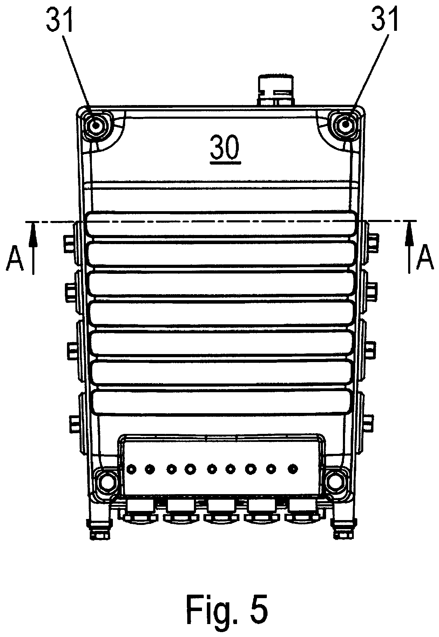

In der Figur 5 ist eine Draufsicht auf das Gehäuse dargestellt.

Wie in den Figuren dargestellt, weist das Gehäuseteil an seiner Unterseite eine Ausnehmung 7 auf, so dass das Gehäuse auf einem Anschlusskastenansatz eines Elektromotors aufsetzbar ist und die Statorleitungen durch die Ausnehmung 7 in den vom Gehäuse umgebenen Innenraum hineinführbar sind.

Im Gehäuse ist eine elektronische Schaltung anordenbar, welche als Umrichter zur Speisung des Elektromotors ausführbar ist. Insgesamt bildet also der Umrichter samt Gehäuse und Elektromotor somit einen Umrichtermotor.

Alternativ ist aber das Gehäuse auch dezentral, also separat, vom Elektromotor anordenbar in einer Anlage. Hierzu wird dann das Gehäuseteil 6 an ein Tragteil oder an ein Gerät angeschraubt.

Zwischen dem Deckelteil 30 und dem Gehäuseteil 6 ist das Rahmenteil 1 anordenbar, welches eine angespritzte Dichtung 2 aufweist. Somit ist das Deckelteil 30 dicht mit dem Gehäuseteil 6 verbindbar. Denn das Rahmenteil 1 weist eine Wandstärke auf, die geringer ist als die Wandstärke der Dichtung 2. Außerdem ist die Dichtung 2 am äußeren Rand des Rahmenteils 1 angeordnet. Somit wird beim Einschrauben der Schrauben 31 in ins Gehäuseteil 6 eingebrachte Gewindebohrungen das Deckelteil 30 mit einer ebenen Verbindungsfläche auf das Rahmenteil 1 gedrückt, welches wiederum auf eine ebene Verbindungsfläche des Gehäuseteils 6 drückt.

Dabei wird die Dichtung 2 elastisch zusammengedrückt und liegt somit dicht an den beiden Verbindungsflächen an.

Die Dichtung 2 weist die erhöhte Wandstärke aber nicht entlang der gesamten Verbindungsfläche zum Deckelteil 30 und zum Gehäuseteil 6 hin auf, sondern die Dichtung 2 weist eine am äußeren Rand des Rahmenteils 1 umlaufende Dichtlippe, welche aus dem restlichen Material der Dichtung 2 hervorragt. Somit ist eine besonders hohe Flächenpressung der Dichtung 2 erreichbar und daher auch eine hohe Schutzart bewirkbar.

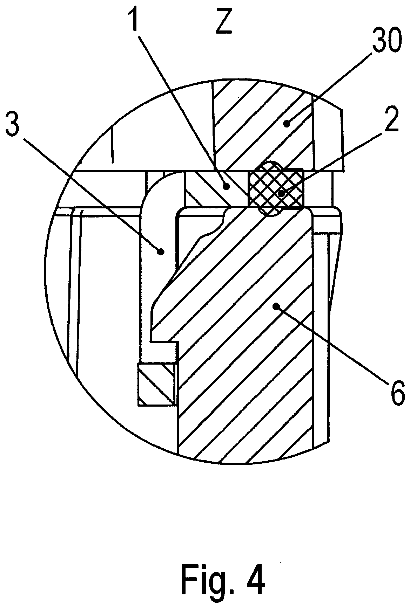

In Figur 4 ist die unverformte Dichtung 2 eingezeichnet, obwohl das Deckelteil 30 und das Gehäuseteil 6 am Rahmenteil 1 anliegen. Der überstehende dort gezeigte Bereich der Dichtung 2 ist der beim realen Verbinden verformte Bereich. Somit wird eine hohe Flächenpressung auf die Dichtung 2 ausgeübt.

Das Rahmenteil 1 weist voneinander beabstandete Laschenbereiche 3 auf, welche in am Gehäuseteil 6 hervorstehende Nasenbereiche 5 eingeklipst werden.

Die Laschenbereiche 3 sind am Rahmenteil 1 um etwa 90° abgebogen, erstrecken sich also senkrecht zu den Verbindungsflächen.

Die Nasenbereiche 5 ragen zum Innenraum hin hervor und weisen eine Einführschräge auf, so dass beim Auflegen des Rahmenteils 1 auf das Gehäuseteil 6 der Laschenbereich der Einführschräge entlanggeführt und dabei zunächst elastisch zunehmend in den vom Gehäuseteil 6 umgebenen Innenraumbereich ausgelenkt wird. Nach Überschreiten des maximal in den Innenraum hineinragenden Punktes des jeweiligen Nasenbereichs 5 schnappt der jeweilige Laschenbereich 3 in eine Vertiefung oder Rücknahme hinter dem jeweiligen Nasenbereich 5 ein.

Außerdem weist das Rahmenteil 1 Ausnehmungen, insbesondere Rundlöcher auf, in welche am Gehäuseteil 6 ausgeformte Zapfen 4 hineinragen, so dass das Rahmenteil 1 positioniert und/oder zentriert ist relativ zum Gehäuseteil 6.

Der jeweilige Zapfen 4 ist an einem Steg ausgebildet, welcher als Verdickung der Wandstärke des Gehäuseteils 6 ausgeführt ist.

Ebenso ist der jeweilige Nasenbereich 5 als Verdickung der Wandstärke des Gehäuseteils 6 ausgeführt.

Die am Außenrand des Rahmenteils 1 umlaufende Dichtlippe der Dichtung 2 verläuft im Bereich der jeweiligen Gewindebohrung 8 zweigeteilt. Somit spaltet sich die Dichtlippe in diesem Bereich auf in einen zum Innenraum hin gewandten, inneren Teil und in einen vom Innenraum abgewandten, äußeren Teil.

Somit ist die Mündung der jeweiligen Gewindebohrung 8 vom Innenraum gesehen beidseitig von der Dichtlippe umgeben und beim Aufsetzen des Deckelteils 30 somit vollständig, insbesondere in alle Richtungen der Verbindungsfläche, abgedichtet.

Bei weiteren erfindungsgemäßen Ausführungsbeispielen wird das Rahmenteil 1 aus demselben Material, insbesondere Aluminium, hergestellt wie das Gehäuseteil 6 und das Deckelteil 30. Somit sind auch bei thermischen Veränderungen keine Störungen des Dichtungssystems bewirkbar.

Bei weiteren erfindungsgemäßen Ausführungsbeispielen wird das Gehäuse zum Einhausen einer anderen Elektronischen Schaltung verwendet. Somit fungiert das Gehäuse dann das Gehäuse als Gehäuse für ein Elektrogerät.

### Bezugszeichenliste

1 Rahmenteil, insbesondere metallisch
2 Dichtung
3 Laschenbereich des Rahmenteils 1
4 Zapfen
5 Nasenbereich
6 Gehäuseteil
7 Ausnehmung
8 Gewindebohrung
30 Deckelteil
31 Schrauben

## Patentansprüche

1. Elektrogerät, insbesondere Umrichtermotor, mit einem Gehäuseteil (6) und einem Deckelteil (30),
wobei ein Rahmenteil (1) zwischen den Gehäuseteil (6) und dem Deckelteil (30) angeordnet ist,
wobei in dem vom aus dem Gehäuseteil (6) und dem Deckelteil (30), insbesondere und dem Rahmenteil (1), gebildeten Gehäuse umgebenen Innenraum eine elektronische Schaltung angeordnet ist,
**wobei** am Rahmenteil (1) eine Dichtung (2) angeordnet ist, insbesondere angespritzt angeordnet ist,
wobei die Dichtung (2) sowohl eine am Deckelteil (30) ausgebildete insbesondere ebene Verbindungsfläche berührt, insbesondere und somit zwischen Rahmenteil (1) und Deckelteil (30) abdichtet, als auch eine am Gehäuseteil (6) ausgebildete insbesondere ebene Verbindungsfläche berührt, insbesondere und somit zwischen Rahmenteil (1) und Gehäuseteil (6) abdichtet,
wobei ein Bereich der Verbindungsfläche des Deckelteils das Rahmenteil (1) berührt,
wobei ein Bereich der Verbindungsfläche des Gehäuseteils das Rahmenteil (1) berührt,
**dadurch gekennzeichnet, dass**
**das Rahmenteil (1) Laschenbereiche (3), insbesondere bügelartig ausgeformte Laschenbereiche (3) aufweist, welche an am Gehäuseteil (6) ausgeformten Nasenbereichen (5), insbesondere an an der Innenwandung des Gehäuseteils in den Innenraum hervorragend angeformten Nasenbereichen (5), formschlüssig gehalten sind, insbesondere eingeklipst sind.**

2. Elektrogerät nach Anspruch 1,
**dadurch gekennzeichnet, dass**
die Dichtung (2) den vom Innenraum aus gesehen äußeren Randbereich des Rahmenteils (1) umgibt,
insbesondere wobei ein erster Bereich der Dichtung (2) auf der dem Deckelteil (30) zugewandten Seite des Rahmenteils (1) angeordnet ist und wobei ein zweiter Bereich der Dichtung (2) auf der dem Gehäuseteil (6) zugewandten Seite des Rahmenteils (1) angeordnet ist.

3. Elektrogerät nach einem der vorangegangenen Ansprüche,
**dadurch gekennzeichnet, dass**
eine durch das Deckelteil (30) und durch das Rahmenteil (1) durchgehende Schraube in eine im Gehäuseteil (6) angeordnete Gewindebohrung (8) eingeschraubt ist, wobei der Schraubenkopf der Schraube das Deckelteil (30) zum Gehäuseteil (6) hindrückt, so dass das Deckelteil (30) das Rahmenteil (1) berührt und, insbesondere auf der vom Deckelteil (30) abgewandten Seite des Rahmenteils (1), das Rahmenteil (1) das Gehäuseteil (6) berührt.

4. Elektrogerät nach einem der vorangegangenen Ansprüche,
**dadurch gekennzeichnet, dass**
das Rahmenteil (1) aus Metall gefertigt ist und die Dichtung (2) aus einem Kunststoff und/oder Gummi.

5. Elektrogerät nach einem der vorangegangenen Ansprüche,
**dadurch gekennzeichnet, dass**
das Rahmenteil (1) im Wesentlichen rechteckförmig ausgeformt ist.

6. Elektrogerät nach einem der vorangegangenen Ansprüche,
**dadurch gekennzeichnet, dass**
der jeweilige Nasenbereich (5) eine Einführschräge aufweist, insbesondere wobei der Nasenbereich (5) in Richtung der Schraubachse der Schraube zunehmend in den Innenraum hervorragt,
insbesondere wobei der Nasenbereich (5) hinter der Einführschräge weniger in den Innenraum hervorragt als im Nasenbereich (5).

7. Elektrogerät nach einem der vorangegangenen Ansprüche,
**dadurch gekennzeichnet, dass**
der jeweilige Nasenbereich (5) als jeweilige Verdickung der Wand des Gehäuseteils ausgeführt ist.

8. **Elektrogerät nach einem der Ansprüche 3 bis** 7,
**dadurch gekennzeichnet, dass**
die Gewindebohrung (8) in einer Verdickung der Wand des Gehäuseteils ausgeführt ist, insbesondere wobei die Verdickung von den Nasenbereichen (5) beabstandet ist und in den Innenraum hervorragt.

9. Elektrogerät nach einem der vorangegangenen Ansprüche,
**dadurch gekennzeichnet, dass**
die Verbindungsflächen parallel zu einer Ebene ausgerichtet sind, deren Normale parallel zur Schraubachsrichtung der Schraube ist.

10. Elektrogerät nach einem der vorangegangenen Ansprüche,
**dadurch gekennzeichnet, dass**
die Laschenbereiche (3) am Rahmenteil (1), insbesondere aus einer zur Ebene parallelen Ebene, in Richtung der Schraubenachse herumgebogen sind

11. Elektrogerät nach einem der vorangegangenen Ansprüche,
**dadurch gekennzeichnet, dass**
das Rahmenteil (1) eine insbesondere in Schraubachsrichtung der Schraube durchgehende Ausnehmung (7) aufweist,
in welche ein am Gehäuseteil (6) ausgeformter Zapfen (4) hineinragt,
insbesondere wobei der Zapfen (4) in einer Verdickung der Wand des Gehäuseteils ausgeführt ist,
insbesondere wobei die Verdickung von den Nasenbereichen (5) beabstandet ist und in den Innenraum hervorragt.

12. Elektrogerät nach einem der vorangegangenen Ansprüche,
**dadurch gekennzeichnet, dass**
das Gehäuseteil (6) an seiner Unterseite eine Ausnehmung (7) aufweist,
wobei das Gehäuseteil (6) auf einem Anschlusskastenansatz eines Elektromotors angeordnet ist,
wobei Statorleitungen des Stators des Elektromotors durch die Ausnehmung (7) in den vom Gehäuse umgebenen Innenraum hineingeführt sind,
insbesondere wobei im Innenraum ein Umrichter angeordnet ist.

13. Elektrogerät nach einem der vorangegangenen Ansprüche,
**dadurch gekennzeichnet, dass**
die Dichtung (2) mit dem Rahmenteil (1) als Verbundteil ausgeführt ist
und/oder dass
die Dichtung (2) auf der zum Deckelteil (30) zugewandten Seite des Rahmenteils (1) eine erste Dichtlippe aufweist, welche am Rahmenteil (1) umlaufend ausgeformt ist und stärker elastisch verformt ist als das restliche Material der Dichtung (2) auf der zum Deckelteil (30) zugewandten Seite des Rahmenteils (1),
wobei die Dichtung (2) auf der zum Gehäuseteil (6) zugewandten Seite des Rahmenteils (1)
eine zweite Dichtlippe aufweist, welche am Rahmenteil (1) umlaufend ausgeformt ist und stärker elastisch verformt ist als das restliche Material der Dichtung (2) auf der zum Gehäuseteil (6) zugewandten Seite des Rahmenteils (1).

14. **Elektrogerät nach Anspruch 3,**
**dadurch gekennzeichnet, dass**
die Schraube durch ein im Rahmenteil (1) angeordnetes Loch hindurchragt, welches in jeder der beiden Verbindungsflächen, insbesondere also am Rahmenteil (1) beidseitig, zum Innenraum hin und zur Umgebung hin von der Dichtung (2) abgedichtet ist und dass
die Dichtung (2) auf der zum Deckelteil (30) zugewandten Seite des Rahmenteils (1) eine erste Dichtlippe aufweist, welche am Rahmenteil (1) umlaufend ausgeformt ist und stärker elastisch verformt ist als das restliche Material der Dichtung (2) auf der zum Deckelteil (30) zugewandten Seite des Rahmenteils (1), wobei die Dichtung (2) auf der zum Gehäuseteil (6) zugewandten Seite des Rahmenteils (1) eine zweite Dichtlippe aufweist, welche am Rahmenteil (1) umlaufend ausgeformt ist und stärker elastisch verformt ist als das restliche Material der Dichtung (2) auf der zum Gehäuseteil (6) zugewandten Seite des Rahmenteils (1)
und/oder dass
die erste Dichtlippe in der ersten der beiden Verbindungsflächen die Schraube vollständig umgibt, insbesondere also zum Innenraum und zur äußeren Umgebung hin abdichtet,
wobei die zweite Dichtlippe in der zweiten der beiden Verbindungsflächen die Schraube vollständig umgibt, insbesondere also zum Innenraum und zur äußeren Umgebung hin abdichtet.

## Claims

1. Electrical device, in particular a converter motor, comprising a housing part (6) and a cover part (30),
a frame part (1) being arranged between the housing part (6) and the cover part (30),
an electronic circuit being arranged in the internal space that is enclosed by the housing formed out of the housing part (6) and the cover part (30), and in particular the frame part (1),
a seal (2) being arranged on the frame part (1), in particular being arranged in an injection-moulded manner,
the seal (2) being in contact with an in particular planar connection surface formed on the cover part (30), and thus in particular providing sealing between the frame part (1) and the cover part (30), and also being in contact with an in particular planar connection surface formed on the housing part (6), and thus in particular providing sealing between the frame part (1) and the housing part (6),
one region of the connection surface of the cover part being in contact with the frame part (1),
one region of the connection surface of the housing part being in contact with the frame part (1),
**characterised in that**
the frame part (1) comprises clip regions (3), in particular clip regions (3) shaped in a stirrup-like manner, which are interlockingly held on, in particular clipped into, lug regions (5) that are shaped on the housing part (6), in particular lug regions (5) that are moulded on the internal wall of the housing part so as to protrude into the internal space.

2. Electrical device according to claim 1,
**characterised in that**
the seal (2) encloses that edge region of the frame part (1) that is external when viewed from the internal space,
a first region of the seal (2) in particular being arranged on the side of the frame part (1) facing the cover part (30), and a second region of the seal (2) being arranged on the side of the frame part (1) facing the housing part (6).

3. Electrical device according to any of the preceding claims,
**characterised in that**
a screw passing through the cover part (30) and the frame part (1) is screwed into a threaded bore (8) arranged in the housing part (6), the screw head of the screw pressing the cover part (30) towards the housing part (6) such that the cover part (30) is in contact with the frame part (1) and the frame part (1) is in contact with the housing part (6), in particular on the side of the frame part (1) facing away from the cover part (30).

4. Electrical device according to any of the preceding claims,
**characterised in that**
the frame part (1) is made of metal and the seal (2) is made of a plastics material and/or rubber.

5. Electrical device according to any of the preceding claims,
**characterised in that**
the frame part (1) is shaped substantially rectangularly.

6. Electrical device according to any of the preceding claims,
**characterised in that**
each lug region (5) comprises an insertion bevel, the lug region (5) in particular increasingly protruding into the internal space in the direction of the screw axis of the screw,
the lug region (5) in particular protruding into the internal space to a lesser extent behind the insertion bevel than in the lug region (5).

7. Electrical device according to any of the preceding claims,
**characterised in that**
each lug region (5) is configured as a particular bulge on the wall of the housing part.

8. Electrical device according to any of claims 3 to 7,
**characterised in that**
the threaded bore (8) is configured in a bulge on the wall of the housing part,
the bulge in particular being arranged at a distance from the lug regions (5) and protruding into the internal space.

9. Electrical device according to any of the preceding claims,
**characterised in that**
the connection surfaces are oriented in parallel with a plane the normal of which is parallel to the screw axial direction of the screw.

10. Electrical device according to any of the preceding claims,
**characterised in that**
the clip regions (3) are bent around the frame part (1), in particular out of a plane parallel to the plane, in the direction of the screw axis.

11. Electrical device according to any of the preceding claims,
**characterised in that**
the frame part (1) comprises an opening (7), which in particular is through-going in the screw axial direction of the screw and into which a pin (4) shaped on the housing part (6) protrudes,
the pin (4) in particular being configured in a bulge on the wall of the housing part,
the bulge in particular being arranged at a distance from the lug regions (5) and protruding into the internal space.

12. Electrical device according to any of the preceding claims,
**characterised in that**
the housing part (6) comprises an opening (7) on its underside,
the housing part (6) being arranged on a junction box attachment of an electric motor, stator lines of the stator of the electric motor being guided through the opening (7) into the internal space enclosed by the housing,
a converter in particular being arranged in the internal space.

13. Electrical device according to any of the preceding claims,
**characterised in that**
the seal (2) is configured as a composite part together with the frame part (1) and/or **in that**
the seal (2) comprises, on the side of the frame part (1) facing the cover part (30), a first sealing lip, which is shaped all around the frame part (1) and is elastically deformed to a greater extent than the rest of the material of the seal (2) on the side of the frame part (1) facing the cover part (30),
the seal (2) comprising, on the side of the frame part (1) facing the housing part (6), a second sealing lip, which is shaped all around the frame part (1) and is elastically deformed to a greater extent than the rest of the material of the seal (2) on the side of the frame part (1) facing the housing part (6).

14. Electrical device according to claim 3,
**characterised in that**
the screw protrudes through a hole that is arranged in the frame part (1) and sealed by the seal (2) towards the internal space and towards the surroundings in each of the two connection surfaces, in particular therefore on both sides on the frame part (1), and **in that** the seal (2) comprises, on the side of the frame part (1) facing the cover part (30), a first sealing lip, which is shaped all around the frame part (1) and is elastically deformed to a greater extent than the rest of the material of the seal (2) on the side of the frame part (1) facing the cover part (30), the seal (2) comprising, on the side of the frame part (1) facing the housing part (6), a second sealing lip, which is shaped all around the frame part (1) and is elastically deformed to a greater extent than the rest of the material of the seal (2) on the side of the frame part (1) facing the housing part (6),
and/or **in that**
the first sealing lip fully encloses the screw in the first of the two connection surfaces, in particular therefore seals it towards the internal space and towards the external surroundings, the second sealing lip fully enclosing the screw in the second of the two connection surfaces, in particular therefore sealing it towards the internal space and towards the external surroundings.

## Revendications

1. Appareil électrique, en particulier moteur de convertisseur, comprenant une partie boîtier (6) et une partie couvercle (30),
une partie cadre (1) étant agencée entre la partie boîtier (6) et la partie couvercle (30), un circuit électronique étant agencé dans l'espace intérieur entouré par le boîtier (6) formé par la partie boîtier (6) et la partie couvercle (30), et en particulier la partie cadre (1),
un joint (2), en particulier moulé par injection, étant agencé au niveau de la partie cadre (1),
le joint (2) touchant une surface de liaison en particulier plane formée sur la partie couvercle (30), et en particulier créant une étanchéité entre la partie cadre (1) et la partie couvercle (30), et touchant également une surface de liaison en particulier plane formée sur la partie boîtier (6), et en particulier créant une étanchéité entre la partie cadre (1) et la partie boîtier (6),
une région de la surface de liaison de la partie couvercle étant en contact avec la partie cadre (1),
une région de la surface de liaison de la partie boîtier étant en contact avec la partie cadre (1),
**caractérisé en ce que**
la partie cadre (1) présente des régions formant languette (3), en particulier des régions formant languette (3) formées en forme d'étrier, qui sont retenues par complémentarité de forme, en particulier clipsées, sur des régions formant ergot (5) formées sur la partie boîtier (6), en particulier sur des régions formant ergot (5) formées de manière saillante sur la paroi intérieure de la partie boîtier au sein de l'espace intérieur.

2. Appareil électrique selon la revendication 1,
**caractérisé en ce que**
le joint (2) entoure la région de bord extérieure, vue depuis l'espace intérieur, de la partie cadre (1),
une première région du joint (2) étant en particulier agencée sur le côté, tourné vers la partie couvercle (30), de la partie cadre (1) et une seconde région du joint (2) étant agencée sur le côté, tourné vers la partie boîtier (6), de la partie cadre (1).

3. Appareil électrique selon l'une quelconque des revendications précédentes,
**caractérisé en ce que**
une vis traversant la partie couvercle (30) et la partie cadre (1) est vissée dans un alésage fileté (8) agencé dans la partie boîtier (6), la tête de la vis poussant la partie couvercle (30) vers la partie boîtier (6) de sorte que la partie couvercle (30) entre en contact avec la partie cadre (1) et la partie cadre (1) entre en contact avec la partie boîtier (6), en particulier sur le côté de la partie cadre (1) qui est opposé à la partie couvercle (30).

4. Appareil électrique selon l'une quelconque des revendications précédentes,
**caractérisé en ce que**
la partie cadre (1) est en métal et le joint (2) est en plastique et/ou en caoutchouc.

5. Appareil électrique selon l'une quelconque des revendications précédentes,
**caractérisé en ce que**
la partie cadre (1) est de forme essentiellement rectangulaire.

6. Appareil électrique selon l'une quelconque des revendications précédentes,
**caractérisé en ce que**
la région formant ergot (5) respective présente une pente d'insertion, la région formant ergot (5) faisant en particulier saillie dans l'espace intérieur de manière croissante dans la direction de l'axe de vissage de la vis,
la région formant ergot (5) située derrière la pente d'insertion faisant en particulier moins saillie dans l'espace intérieur que dans la région formant ergot (5).

7. Appareil électrique selon l'une quelconque des revendications précédentes,
**caractérisé en ce que**
la région formant ergot (5) respective est réalisée sous la forme d'un épaississement respectif de la paroi de la partie boîtier.

8. Appareil électrique selon l'une quelconque des revendications 3 à 7,
**caractérisé en ce que**
l'alésage fileté (8) est réalisé dans un épaississement de la paroi de la partie boîtier, l'épaississement se trouvant en particulier à distance des régions formant ergot (5) et faisant saillie dans l'espace intérieur.

9. Appareil électrique selon l'une quelconque des revendications précédentes,
**caractérisé en ce que**
les surfaces de liaison sont orientées parallèlement à un plan dont la normale est parallèle à la direction de l'axe de vissage de la vis.

10. Appareil électrique selon l'une quelconque des revendications précédentes,
**caractérisé en ce que**
les régions formant languette (3) sont repliées au niveau de la partie cadre (1) en direction de l'axe de vissage, en particulier à partir d'un plan parallèle audit plan.

11. Appareil électrique selon l'une quelconque des revendications précédentes,
**caractérisé en ce que**
la partie cadre (1) présente un évidement (7) traversant, en particulier dans la direction de l'axe de vissage de la vis, au sein duquel un tenon (4) formé sur la partie boîtier (6) fait saillie,
le tenon (4) étant en particulier réalisé dans un épaississement de la paroi de la partie boîtier,
l'épaississement se trouvant en particulier à distance des régions formant ergot (5) et faisant saillie dans l'espace intérieur.

12. Appareil électrique selon l'une quelconque des revendications précédentes,
**caractérisé en ce que**
la partie boîtier (6) présente un évidement (7) sur sa face inférieure,
la partie boîtier (6) étant agencée sur une garniture de raccordement d'un moteur électrique,
des lignes de stator du stator du moteur électrique étant introduites à travers l'évidement (7) dans l'espace intérieur entouré par le boîtier,
un convertisseur étant en particulier agencé dans l'espace intérieur.

13. Appareil électrique selon l'une quelconque des revendications précédentes,
**caractérisé en ce que**
le joint (2) est réalisé avec la partie cadre (1) sous la forme d'une pièce composite et/ou **en ce que**
le joint (2) présente, sur le côté de la partie cadre (1) qui est tourné vers la partie couvercle (30), une première lèvre d'étanchéité qui est formée sur le pourtour de la partie cadre (1) et est déformée de manière plus élastique que le reste de matériau du joint (2) sur le côté de la partie cadre (1) qui est tourné vers la partie couvercle (30), le joint (2) présentant, sur le côté de la partie cadre (1) qui est tourné vers la partie boîtier (6), une seconde lèvre d'étanchéité qui est formée sur le pourtour de la partie cadre (1) et est déformée de manière plus élastique que le reste de matériau du joint (2) sur le côté de la partie cadre (1) qui est tourné vers la partie boîtier (6).

14. Appareil électrique selon la revendication 3,
**caractérisé en ce que**
la vis traverse un trou, agencé dans la partie cadre (1), qui, grâce au joint (2), est rendu étanche par rapport à l'espace intérieur et par rapport à l'environnement dans chacune des deux surfaces de liaison, en particulier des deux côtés au niveau de la partie cadre (1), et **en ce que** le joint (2) présente, sur le côté de la partie cadre (1) qui est tourné vers la partie couvercle (30), une première lèvre d'étanchéité qui est formée sur le pourtour de la partie cadre (1) et est déformée de manière plus élastique que le reste de matériau du joint (2) sur le côté de la partie cadre (1) qui est tourné vers la partie couvercle (30), le joint (2) présentant, sur le côté de la partie cadre (1) qui est tourné vers la partie boîtier (6), une seconde lèvre d'étanchéité qui est formée sur le pourtour de la partie cadre (1) et est déformée de manière plus élastique que le reste de matériau du joint (2) sur le côté de la partie cadre (1) qui est tourné vers la partie boîtier (6),
et/ou **en ce que**
la première lèvre d'étanchéité entoure complètement la vis dans la première des deux surfaces de liaison, en particulier en la rendant étanche par rapport à l'espace intérieur et par rapport à l'environnement extérieur,
la seconde lèvre d'étanchéité entourant complètement la vis dans la seconde des deux surfaces de liaison, en particulier en la rendant étanche par rapport à l'espace intérieur et par rapport à l'environnement extérieur.
